Europäisches Patentamt

European Patent Office

Office européen des brevets

(19)

(11) Publication number : **0 463 817 A2**

# EUROPEAN PATENT APPLICATION

(12)

(21) Application number : **91305630.5**

(22) Date of filing : **21.06.91**

(51) Int. Cl.$^5$ : **H01L 27/108**

(30) Priority : **22.06.90 JP 162799/90**

(43) Date of publication of application :
**02.01.92 Bulletin 92/01**

(84) Designated Contracting States :
**DE FR NL**

(71) Applicant : **Oki Electric Industry Co., Ltd.
7-12, Toranomon 1-chome Minato-ku
Tokyo (JP)**

(72) Inventor : **Tanaka, Hiroyuki, c/o Oki Electric
Ind. Co.,Ltd.
7-12 Toranomon 1-chome
Minato-ku, Tokyo (JP)**

(74) Representative : **Read, Matthew Charles et al
Venner Shipley & Co. 368 City Road
London EC1V 2QA (GB)**

(54) Gain cell structure for DRAM and fabrication process thereof.

(57)    A gain cell structure for a DRAM comprises a semiconductor substrate (1) in which are formed the source and drain regions (4, 5) of a read IGFET. An insulating layer (3) is formed over the surface of the substrate (1) and a monocrystalline semiconductor layer formed thereon. The source (8) and drain (9) regions of a write IGFET are formed in the monocrystalline layer with the source region (8) overlying the channel of the read IGFET, forming a gate electrode therefor. The insulating layer is interrupted in the region of the channel of the write IGFET. A further insulating layer (10) is formed on the monocrystalline layer and the gate (7) of the write IGFET and a capacitor plate (11), which forms a capacitor with the source region (8) of the write transistor, are formed thereon. Further insulation (12) and a metallisation (13) layer are then formed over the gain cell.

EP 0 463 817 A2

## BACKGROUND OF THE INVENTION

### 1) Field of the Invention

The present invention relates to the structure of gain cells suitable for use, especially, in a semiconductor storage device such as a dynamic random access memory (DRAM) and also to a fabrication process thereof.

### 2) Description of the Related Art

Memory cells in conventional DRAM generally make use of a stacked capacitor to have an increased memory capacity. A capacitor itself is a passive device having no amplifying function. Therefore, the progressive reduction in such a memory cell area has led to a reduction in signal charge and hence to a reduction in signal voltage. To cope with this problem, there is a current trend toward the use of gain cells, which are memory cells having amplifying function by themselves, as memory cells for DRAM. For example, a conventional technique in which gain cells are used as memory cells for DRAM is disclosed by H. Shichijo et al. in "TITE RAM: A NEW SOI DRAM Gain Cell for Mbit DRAM's", NIKKEI ELECTRONICS, pp262-266 (October 7, 1985) and Ext. Abs. 16th Conf. on Solid State Devices & Materials, Kobe, pp265-268 (1984). As is described in these publications, when a gain cell is used as a memory cell in DRAM, it has been the conventional practice that the gain cell has a write transistor and a read transistor, both formed on an oxide film and the write transistor is composed of a polycrystalline silicon MOSFET. Namely, the DRAM is structurally in such a configuration that polycrystalline silicon transistors are connected to floating gates of EPROM, respectively.

Because of the use of polycrystalline silicon transistors as write transistors, the above-mentioned conventional technique involves the inherent problem of deteriorations in characteristics such as a reduction in charge retention time due to a leak current and an increase in writing time due to lowered mobility. It is however extremely difficult to set process conditions so that such variations in characteristics can be avoided. As a matter fact, it has been practically impossible to establish such process conditions.

## SUMMARY OF THE INVENTION

An object of the present invention is to overcome such drawbacks of the prior art, and hence to provide a gain cell structure for a dynamic random access memory - which is free of deteriorations in characteristics such as a reduction in charge retention time due to a leak current and an increase in writing time due to lowered mobility - and also a fabrication process thereof.

This invention therefore provides a gain cell suitable for use as a memory cell in a semiconductor memory device. The gain cell comprises a write transistor portion for being driven upon writing data and a read transistor portion for being driven upon reading data. The write transistor portion is formed as a monocrystalline silicon layer.

The present invention also provides a process for the fabrication of a gain cell structure. According to the process, a first oxide film is formed on a semiconductor substrate and a first diffused layer is formed in the semiconductor substrate. The first oxide film is to be formed into a field oxide film and a gate oxide film, while the first diffused layer is to be formed into a read bit line and a power supply line. A part of the first oxide film is removed. Amorphous silicon is deposited on the substrate with the first oxide film formed thereon. The silicon is then converted to a single crystal to form a monocrystalline silicon layer. The monocrystalline silicon layer is removed at regions other than regions where a write transistor is to be formed. A second oxide film is formed on the monocrystalline silicon layer and a gate electrode of polycrystalline silicon is then patterned on the second oxide film. A second diffused layer is next formed in the monocrystalline silicon layer while using the gate electrode as a mask. This second diffused layer is to be formed into a charge storage layer and also into a drain of the write transistor. An insulating film is formed on the second diffused layer, followed by the formation of an electrode above the charge storage layer.

According to the present invention, the transistor of each gain cell is formed without using any polycrystalline silicon transistor. This has made it possible to improve the charge retention time and also to shorten the writing time. In addition, the process control has become easier.

Further scope of applicability of the present invention will become apparent from the detailed description and specific examples, which merely indicate certain preferred embodiments of the invention and are given by way of illustration only, since various changes and modifications within the spirit and scope of the invention will become apparent to those skilled in the art from this detailed description.

## BRIEF DESCRIPTION OF SEVERAL VIEWS OF DRAWINGS

These and other features and advantages of the invention may be more completely understood from the following detailed description of the preferred embodiments of the invention with reference to the accompanying drawings in which:

FIG. 1(a) and FIG. 1(b) illustrate a gain cell structure according to one embodiment of the present invention as applied to a dynamic random access memory;

FIG. 2(a) through FIG. 2(d) are cross-sectional views showing various steps of a fabrication process as applied for the fabrication of the gain cell structure of FIGS. 1(a) and 1(b); and

FIG. 3 is a circuit diagram depicting an exemplary circuit construction for the gain cell structure.

## DETAILED DESCRIPTION OF THE INVENTION

Referring next to the accompanying drawings, the gain cell structure according to the one embodiment of the present invention, which is suitable for use in a dynamic random access memory (DRAM), and one example of its fabrication process will be described in detail.

FIGS. (1a) and (1b) are structure drawings illustrating one embodiment in which the gain cell according to the present invention is used as a memory cell in DRAM. These figures show the structure of gain cells of DRAM, to which structure the present invention relates directly. A plurality of such gain cells are arranged two-dimensionally as memory cells so that DRAM is constructed. The structure of this embodiment is substantially different from the gain cell structure of conventional DRAM in that a write transistor is formed on monocrystalline silicon. In the gain cell structure according to this embodiment, a charge storage layer 8, said charge storage layer 8 being a gate electrode of a read transistor and also a source region of a write transistor, a drain region 9 of the write transistor, and a channel region of the write transistor, said channel region being located between the charge storage layer 8 and the drain region 9, have been formed by LSPE (lateral solid phase epitaxy) of silicon. As is clearly envisaged from the foregoing, no polycrystalline silicon transistor is employed in this embodiment.

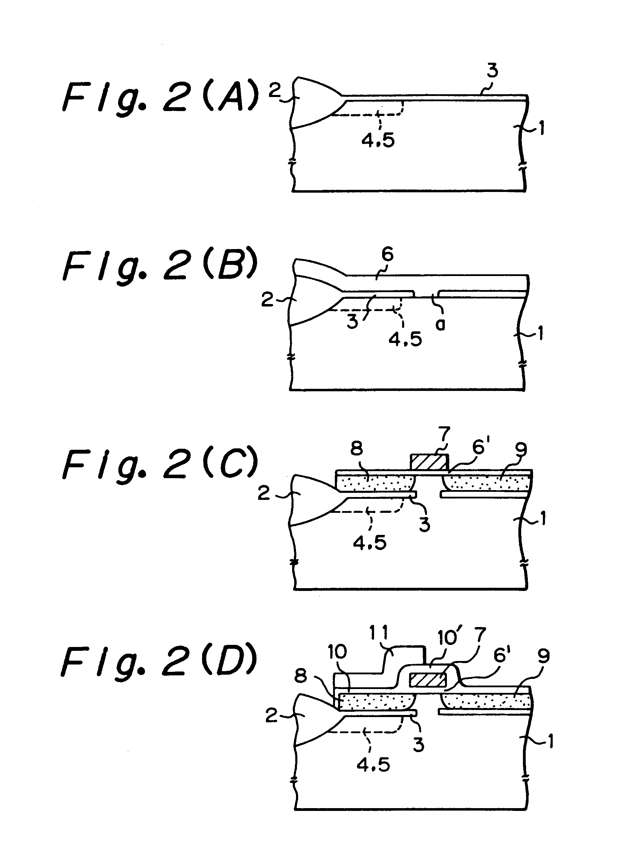

FIG. 2(a) to FIG. 2(d) depict one example of the fabrication process in cross-section. The fabrication process in this example will hereinafter be described in detail with reference to FIGS. 2(a) to 2(d).

Reference is first made to FIG. 2(a), in which a field oxide film 2 is formed on a silicon substrate 1 by a conventional method and an oxide film 3 is then formed, for example, to a thickness of about 100 Å by thermal oxidation. A portion of this oxide film 3 will become a gate oxide film of a read transistor. A diffused layer which will become a read bit line 4 and a power supply line 5 are then formed by ion implantation of phosphorus or arsenic through a resist (not shown) as a mask and subsequent heat treatment.

Next, as is illustrated in FIG. 2(b), a portion a (which corresponds to a region located underneath a gate electrode 7 of the write transistor, said gate electrode 7 being to be formed in a subsequent step) of the oxide film 3 is removed (boring of a window) by photolithography. Amorphous silicon is thereafter deposited to a thickness of 0.1-0.5 μm, typically 0.3 μm in an ultra-high vacuum. By subsequent heat treatment at 550-650°C for 2-50 hours, for example, at about 600°C for approximately 10 hours in a nitrogen gas atmosphere, a silicon LSPE layer 6, namely, a monocrystalline silicon layer is formed.

As is shown in FIG. 2(c), the silicon LSPE layer 6 is removed at regions other than those to be formed into the source region 8, drain region 9 and channel region of the write transistor in a subsequent step, followed by the formation of a gate oxide film 6' of the write transistor to a thickness of about 100 Å through thermal oxidation. Polycrystalline silicon containing a dopant such as phosphorus is next deposited to a thickness of about 0.3 μm by LPCVD or the like on the oxide film 6'. The polycrystalline silicon is then etched, whereby the gate electrode 7 (write word line) of the write transistor is formed. Using the gate electrode 7 as a mask, the charge storage layer 8 - which is the gate electrode of the read transistor and also the source region of the write transistor - and the drain region 9 of the write transistor are then formed by a known method such as ion implantation.

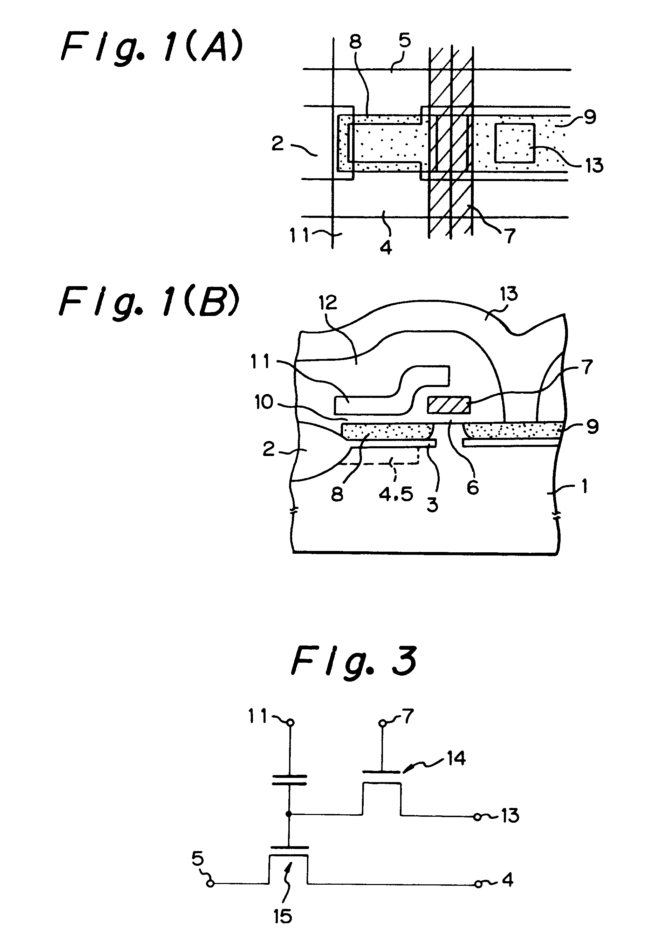

Thereafter, the oxide film 6 is once removed at regions other than that lying underneath the gate electrode 7. As depicted in FIG. 2(d), an oxide film 10 is again formed to a thickness of about 100 Å by thermal oxidation. This oxide film 10 is formed on the top of the charge storage layer 8 and serves as an insulating film of a capacitor. At this time, a sufficiently thick oxide film 10 is formed on the gate electrode 7 of the write transistor by enhanced oxidation of the phosphorus-doped polycrystalline silicon. Polycrystalline silicon which contains a dopant such as phosphorus is next deposited to a thickness of about 0.3 μm by LPCVD, followed by the formation of an electrode, namely, a read word line 11 by photolithography. An intermediate insulating layer 12 [see FIG. 1(b)] is then formed. This intermediate insulating layer 12 is removed at a region located above the drain region 9 of the write transistor, and a write bit line 13 is formed with aluminum so that the removed region of the intermediate insulating layer 12 is filled out. The structure of FIGS. 1(a) and 1(b) is obtained by the above fabrication process.

In the above example, subsequent to the formation of the oxide film 3, LSPE was used to form a single crystal of silicon on the oxide film 3. A single crystal of silicon can also be formed by depositing amorphous silicon or polycrystalline silicon and then exposing it to a laser beam in order to have it recrystallized.

FIG. 3 shows the circuit diagram of the embodiment depicted in FIGS. 1(a) and 1(b). Circuit operation in the above embodiment will next be described briefly with reference to FIG. 3. Upon writing, a datum of logic value "1" or logic value "0" on the write bit line 13 is written in the charge storage layer 8 via the write transistor. Of course, the word lines 7,11 are maintained at a high positive potential at this time. After the datum has been written in the write transistor, the write transistor is turned off so that the charge storage layer 8 electrically floats. Upon reading on the other hand, a driving voltage is applied via the read word line 11 so that, by capacitive coupling, the potential of the gate electrode 8 of the read transistor increases. As a result, a datum stored in the transistor is outputted to the read bit line 1.

Although not specifically mentioned in the above description, the read transistor is not formed of polycrystalline silicon like the prior art as is apparent from the manner of its formation.

As has been described above, the gain cell according to the present invention, which is suitable for use in DRAM, does not use polycrystalline silicon as each transistor but each transistor is constructed in the form of a monocrystalline silicon layer. Compared with a gain cell making use of polycrystalline silicon, the gain cell according to the present invention has made it possible to lower the leak current so that the charge retention time and the mobility have been improved and the writing time has hence been shortened. As a consequence, the characteristics have been improved substantially. Further, the process control has been rendered easier because a monocrystalline silicon layer is formed by LSPE and each transistor is formed there.

## Claims

1. A gain cell suitable for use as a memory cell in a semiconductor memory device, comprising:
   a write transistor portion for being driven upon writing data, said write transistor portion being formed as a monocrystalline silicon layer; and
   a read transistor portion for being driven upon reading data.

2. A dynamic random access memory comprising a plurality of memory cells each of which has the same structure as the gain cell of claim 1.

3. A process for the fabrication of a gain cell structure, which comprises the steps of:
   (a) forming a first oxide film on a semiconductor substrate and a first diffused layer in the semi-conductor substrate, said first oxide film being to be formed into a field oxide film and a gate oxide film and said first diffused layer being to be formed into a read bit line and a power supply line;
   (b) removing a part of said first oxide film, depositing amorphous silicon on the substrate with the first oxide film formed thereon, and then converting the silicon into a single crystal to form a monocrystalline silicon layer;
   (c) removing the monocrystalline silicon layer at regions other than regions where a write transistor is to be formed, forming a second oxide film on the monocrystalline silicon layer, and then patterning a gate electrode of polycrystalline silicon on the second oxide film;
   (d) forming a second diffused layer in the monocrystalline silicon layer while using the gate electrode as a mask, said second diffused layer being to be formed into a charge storage layer and also into a drain of the write transistor; and
   (e) forming an insulating film on the second diffused layer and then forming an electrode above the charge storage layer.

4. The process of claim 3, wherein, upon formation of the monocrystalline silicon layer in the step (b), the single crystal of silicon is formed by LSPE

5. The process of claim 4, wherein, upon formation of the monocrystalline silicon layer in the step (b), the single crystal of silicon is formed by removing the part of the first oxide film by photolithography, depositing amorphous silicon in an ultra-high vacuum and then subjecting the amorphous silicon to heat treatment.

6. The process of claim 5, wherein the amorphous silicon is deposited to the thickness of 0.1-0.5 $\mu$m.

7. The process of claim 5, wherein the heat treatment is conducted at 550-650°C for 2-50 hours in a nitrogen atmosphere.

8. The process of claim 3, wherein the step (b) for forming the single crystal of silicon comprises depositing amorphous silicon and exposing the amorphous silicon to a laser beam.

9. The process of claim 3, wherein the step (b) for forming the single crystal of silicon comprises depositing polycrystalline silicon and exposing the amorphous silicon to a laser beam.

10. A gain cell suitable for use as a memory cell in a semiconductor memory device comprising a write IGFET and a read IGFET characterised in that the source region of the write IGFET functions as the gate of the read IGFET.

## F l g. 1 (A)

## F l g. 1 (B)

## F l g. 3

$Fig.\ 2(A)$

$Fig.\ 2(B)$

$Fig.\ 2(C)$

$Fig.\ 2(D)$